Europäisches Patentamt

(19) European Patent Office

Office européen des brevets

(11) Publication number: **0 024 111**
**A1**

(12) **EUROPEAN PATENT APPLICATION**

(21) Application number: **80302300.1**

(22) Date of filing: **07.07.80**

(51) Int. Cl.³: **H 01 G 9/20**
**H 01 M 14/00**

(30) Priority: **27.07.79 IL 57908**

(43) Date of publication of application:
**25.02.81 Bulletin 81/8**

(84) Designated Contracting States:
**AT BE CH DE FR GB IT LI LU NL SE**

(71) Applicant: **YEDA RESEARCH AND DEVELOPMENT COMPANY, LTD.**
**Weizmann Institute of Science Herzl Street at Yavne Road**
**Rehovot(IL)**

(72) Inventor: **Hodes, Gary**
**Bar Shaul 6**
**Rehovot(IL)**

(72) Inventor: **Cahen, David**
**Kipnis 3**
**Rehovot(IL)**

(72) Inventor: **Manassen, Joost**
**Yad Weizmann Gate**
**Rehovot(IL)**

(74) Representative: **Lawrence, Peter Robin Broughton et al,**
**Gill, Jennings & Every 53-64 Chancery Lane**
**London WC2A 1HN(GB)**

(54) **Photovoltaic systems, semiconductor photoelectrodes and processes of making semiconductors.**

(57) A photovoltaic system may comprise a Cd(SeTe) alloy junction-forming material, preferably as a photoelectrode. A photoelectrode suitable for use in a photovoltaic system may comprise a Cd(SeTe) alloy. A semiconductor suitable for use as a photoelectrode may be made by a method comprising electrodepositing Cd(SeTe) onto a substrate followed by heat treatment or by applying a slurry providing Cd(SeTe) and then annealing the slurry.

EP 0 024 111 A1

Croydon Printing Company Ltd.

1 YEDA RESEARCH AND DEVELOPMENT
CO. LTD.    GJE 6080/101

PHOTOVOLTAIC SYSTEMS, SEMICONDUCTOR PHOTOELECTRODES
AND PROCESSES OF MAKING SEMICONDUCTORS

Photovoltaic devices, especially devices for direct conversion of radiant energy into electrical energy by means of a photoelectrochemical cell (hereinafter referred to as PEC) are known from, for instance, US Patent No. 4,064,326.

The photoelectrode is in many respects the most important part of the PEC as it determines the maximum possible energy conversion efficiency of the device.   U.S. Patent No. 4,064,326 discloses a series of materials that may be used as photoelectrodes and redox couples which enable the stable use of such photoelectrodes. A CdTe photoelectrode has a 1.45 eV optical bandgap and is eminently suited for photovoltaic solar energy conversion (0.3 eV lower than CdSe, which may be used in stable $S/S^=$ PEC's) but a major problem in such PEC's is the necessity of using deeply coloured, highly oxygen sensitive, poisonous $Se/Se^=$ and/or $Te/Te^=$ redox couples with the CdTe photoelectrode.

The electrical and thermal properties, specifically the electrical conductivity, Hall constant, thermoelectric power and thermal conductivity of alloys of CdTe and CdSe have been investigated by Stuckes and Farrell (J. Phys. Chem. Sol. 25, 477, (1964)). Corodetskii et al studied the photoconductivity of such alloys (Chem. Abstr. 77; 157719d); Gavrilenko et al reported on the temperature dependence of space charge limited currents in diode structures containing

2

$CdTe_{0.7}Se_{0.3}$ (Chem. Abstr. 87; 110180). Berishvili et al studied the voltage-current characteristics of CdSe/CdTe alloys with In contacts, with emphasis on their photoconductive properties (poluprovodn. Tekh. Mikroelektron., 28, 23 (1978)). Strauss and Steininger (J. Electrochem. Soc. 117, 1420 (1970)) have described the quilibrium phase diagram of $(CdTe)_{1-x}(CdSe)_x$ and defined the quilibrium conditions for formation of hexagonal (wurtzite) and cubic (zincblende) structure. Tai, Nakashima and Hori (Phys. Stat. Sol. (a) 30, K115 (1975)) describe the optical properties of the CdTe/CdSe alloys and find an optical bandgap minimum of $\sim$1.40 eV for compositions containing between 30 and 50% CdSe in the cubic structure and of $\sim$1.45 eV for compositions containing between 40 and 65% CdSe in the hexagonal structure.

No uses of the CdSe/CdTe alloys as photoelectrodes, or in photovoltaic devices in general, have been described.

According to the invention, a photovoltaic system is provided which comprises a Cd(SeTe) alloy as junction forming material. The preferred photovoltaic system is a photoelectrochemical cell and the cell comprises a semi-conductor photoelectrode comprising a Cd(SeTe) alloy.

The invention includes also the novel photoelectrodes. The semi-conductor photoelectrode preferably comprises a semi-conductor layer formed predominantly of the alloy, for instance comprising at least about 90 atom-% Cd (SeTe). The layer may consist essentially of or even entirely of Cd(SeTe) alloy.

However the layer may comprise additionally a chalcogenide of cadmium, zinc or mercury or mixtures thereof generally in an amount up to 10 atom %. When the additional chalcogenide is of cadmium the chalcogen is sulphur or oxygen. The additional chalcogenide may be present as a component of the alloy.

The alloy may comprise from about 20 to about 90

3

atom-% CdSe and from about 10 to about 80 atom-% CdTe. Preferably the allow comprises between about 30 to 90 atom-%, most preferably 40 to 75 atom-%, CdSe and preferably 10 to 70 atom-%, most preferably 25 to 0 atom-%, CdTe.

The preferred structure of the alloy for use in a PEC is a hexagonal wurtzite-like structure, the alloy preferably containing 30 to 90 atom-% CdSe.

The active part of the photoelectrode may be in the form of a single crystal, pressed pellet or thin film, epitaxially grown or polycrystalline of Cd (Se, Te) on a suitable electrically conducting substrate such as Ti, Cr-plated steel, graphite, or electrically conducting transparent glass.

The invention includes also preferred processes for preparing semiconductors, and especially the described photoelectrodes. In one method CdSe and CdTe are electro-codeposited onto an electrically conductive substrate and the codeposited CdSe and CdTe is subsequently heated. The heat treatment is preferably performed under conditions sufficient to anneal the deposited material.

A thin Cd(Se, Te) film also may be prepared by vapour deposition techniques such as spray pyrolysis, vacuum evaporation or sputtering.

In another preferred process, the photoelectrode or other semiconductor may be prepared by the steps of preparing a slurry of CdSe and CdTe and then painting or otherwise applying the slurry to an electrically conductive substrate. The substrate coated with the slurry is then annealed at an elevated temperature. The slurry itself may be made by preparing a powder formed by mixing granular CdSe and CdTe and then grinding the mixture. The solid particles may be prepared by high temperature reaction of the elements, electrochemically or by any other suitable method. The ground mixture is then fired and then cooled. Finally, the cooled mixture is ground. This slurry contains

4

the parent materials in the desired proportions, mixed with suitable liquid carrier which efficiently wets the solid particles, so that the resulting slurry has a suitable viscosity for application to the substrate.

Broadly, when forming a semiconductor layer of Cd(SeTe) alloy on a substrate by applying a slurry of CdSe and CdTe followed by annealing, the slurry preferably includes a fluxing agent, for instance cadmium chloride. The slurry is preferably made as described above with the fluxing agent being added after the cooling of the ground and fired mixture.

5

Photoelectrochemical cells containing semiconductor photoelectrodes according to the invention advantageously comprise polychalcogenide (S, Se, Te)-containing electrolytes and preferably the photovoltaic system comprises an electrolyte comprising an $S/S^=$ redox couple.

The new photoelectrodes yield a good and generally an improved utilisation of the solar spectrum for direct conversion of solar energy to electrical energy by a good and generally improved match of the semiconductor light absorption characteristics to the solar spectrum.

Because of the nature of this conversion process there exists an optimal bandgap region, which depends somewhat on the air-mass through which the solar energy reaches the device, and this optimum lies around 1.4 eV. CdTe, which has an optical bandgap in this optimum region, generally cannot be used in a PEC unless highly coloured, very oxygen sensitive and poisonous $Te/Te^=$ or $Se/Se^=$ redox couples are added to the electrolyte to form a stable system. In $S/S^=$-containing electrolytes the semi-conductor rapidly deactivates, i.e. is unstable. On the other hand CdSe-based PEC's are stable in the less coloured, less poisonous, less oxygen sensitive and cheaper $S/S^=$-containing electrolytes, but CdSe has a 1.7 eV bandgap, resulting in less than optimal use of solar energy.

Surprisingly, the use of Cd(SeTe) alloys in photovoltaic devices, especially PEC's, has proved very advantageous, especially when the alloy contains between 30 and 90 atom-% CdSe, and preferably between 40 and 75 atom-% CdSe. Such alloys have bandgaps lower than CdSe, and at certain compositions even lower than CdTe. These alloys can be used in $S/S^=$ containing electrolytes and such systems are surprisingly stable over a wide composition range, in contrast to pure CdTe-based PEC's in this electrolyte. PEC's based on Cd(SeTe) alloys have a performance superior to those based

6

on pure CdSe as they can give higher photocurrents, because of their lower bandgap, without seriously affecting their photovoltage.

Example 1

A powder of nominal composition $CdSe_{0.65}Te_{0.35}$ is prepared as follows:

99.999% CdSe (3 μ grain size) and CdTe (99.99% ~10 μ grain size) are mixed in 13:7 molar ratio with 25% w/w $CdCl_2$ . 2.5 $H_2O$. This mixture is ground with 2 drops of ethanol per 100 mg mixture and is allowed to dry at room temperature. The dried powder is fired at $660^oC$ for 40 min. in an atmosphere containing 10 ppm $O_2$ in Ar, and cooled subsequently in the same atmosphere.

A paint is formed comprising a mixture of the powdered alloy, obtained by light grinding, and $CdCl_2.2.5$ $H_2O$ acting as a fluxing agent in a ratio of 50:3 w/w ground together with a mixture of ·5% (v/v) nonionic detergent in water to give a smooth slurry.  For each 50 mg of powder, 0.05 ml of the detergent solution is used.

A titanium substrate is preoxidised by being preheated for 40 secs in an atmosphere of 20 ppm $O_2$, in Ar at $650^{o}C$ and is then coated with the paint to produce a 0.22 $cm^2$ (dry weight) photoelectrode layer.

The covered substrate is dried at room temperature and heated under the same conditions as used for the Ti substrate, but for 12 mins.  It then is cooled slowly (over a 5 minute period) to room temperature in the same atmosphere.

The thus annealed, cooled substrate is used in a PEC, further comprising a sulphided brass gauze counterelectrode (as described in British Patent Application No. 8003410 and Israeli application 56621) and an aqueous 1 molar solution each in KOH, $Na_2S.9H_2O$ and S. Under 0.85 AM1 illumination, and after etching for 5 seconds in 3% HNO in conc. HCl (v/v) followed by dipping in 0.1 M $K_2CrO_4$ in water, this PEC gave a 3.15 mA short-circuit current, 440 mV at 2.19 mA over optimal load, 625 mV open-circuit potential (5.1% conversion efficiency).  Under ~3xAm1 conditions, this PEC showed no deactivation after 50 hrs of continuous operation at short circuit current.  The semi-conductor layer had a hexagonal (wurtzite-like) structure, as verified by X-ray diffraction.

Example 2

A substrate of Cr-plated steel was prepared by plating mechanically cleaned steel in a solution of 3M $CrO_3$ and 0.026M $H_2SO_4$ in $H_2O$, using a Pt anode and a current density of 200 $mA/cm^2$, for 10 mins, at room temperature and was subsequently heated under the same conditions as the Ti substrate in example 1, but for 3 minutes.  An electrode was prepared from this substrate as in Example 1, but using a 65:35 molar ratio mixture of CdSe and CdTe.

An electrode made by this method and having an

area of 1 cm$^2$, when used in a PEC as in example 1, gave a short circuit current of 8.5 mA, an open circuit voltage of 570 mV and 385 mV over 70 Ω optimal photopotential, yielding 2.1 mW under 0.82 Aml simulated conditions ( ∿2.6% conversion efficiency). Under 3.5xAM1 conditions this electrode was stable for a period corresponding to more than one month under AM1 illumination.

Example 3

A piece of titanium metal, 3 x 1 cm, was preoxidised as in Example 1. An area of 1 x 1 cm of this Ti was immersed in a 2 N aqueous solution of $H_2SO_4$ containing 0.5 M $CdSO_4$ and saturated with $TeO_2$ at room temperature with stirring. When the Ti was connected through an ammeter to a Cd rod immersed in the same solution, a current of 4 mA was registered. Small quantities of $SeO_2$ were added (of the order of millimolar concentrations) until the current reached 16 mA. Electrolysis was continued for 10 minutes.

The resulting electrode of composition $CdSe_{0.75}Te_{0.25}$ (calculated from the relative current contributions of the $TeO_2$, and $SeO_2$) was annealed under the same conditions as for Example 1, but at 625°C. The electrode was etched for 10 sec. in a 50-50 (v/v) solution of HCl in water, and then blanked off by a laquer of tar in toluene to 0.65 cm$^2$. Under simulated AM1 conditions, this electrode gave in 1 M each of KOH, $Na_2S.9H_2O$ and S, a short circuit current of 7.5 mA, an open circuit voltage of 530 mV and a fill factor of 39% yielding a conversion efficiency of 2.4%.

9

CLAIMS

1.      An article that is a photovoltaic system comprising a junction-forming material that includes a compound including cadmium, characterised in that the junction forming material comprises a Cd(SeTe) alloy.

2.      An article according to claim 1 characterised in that the system comprises a photoelectrochemical cell that includes a semiconductor photoelectrode characterised in that the photoelectrode comprises the Cd(SeTe) alloy.

3.      An article according to claim 1 or claim 2 characterised in that the system includes an electrolyte comprising an $S/S^=$ redox couple.

4.      An article that is a semiconductor photoelectrode and that is characterised in that it comprises a Cd(SeTe) alloy.

5.      An article according to any preceding claim characterised in that the alloy is present as a semiconductor layer formed predominantly of the Cd(SeTe) alloy.

6.      An article according to claim 5 characterised in that at least 90 atom-% of the semiconductor layer is provided by Cd(SeTe).

7.      An article according to claim 5 or claim 6 characterised in that the layer additionally comprises up to about 10 atom % of a chalcogenide of a member selected from zinc or mercury or mixtures thereof.

8.      An article according to any of claims 5 to 7 characterised in that the layer additionally contains up to about 10 atom % cadmium sulphide or oxide.

9.      An article according to claim 5 in which the layer consists substantially only of the Cd(SeTe) alloy.

10.      An article according to any preceding claim characterised in that the alloy comprises about 30 atom-%, to about 90 atom-% CdSe.

11.      An article according to claim 10 characterised in that the alloy comprises about 40 atom-% to about 75 atom-% CdSe.

12.      An article according to claim 2 or claim 4 characterised in that the alloy has a hexagonal wurtzite-like structure and comprises 30 atom % to 90 atom % CdSe.

13.      A process of preparing a semiconductor suitable for use as a photoelectrode according to claim 4 characterised in that it comprises electrodepositing Cd(SeTe) onto an electrically conductive substrate and heat treating the deposited Cd(SeTe).

European Patent Office

**EUROPEAN SEARCH REPORT**

| | DOCUMENTS CONSIDERED TO BE RELEVANT | | CLASSIFICATION OF THE APPLICATION (Int. Cl.³) |
|---|---|---|---|
| Category | Citation of document with indication, where appropriate, of relevant passages | Relevant to claim | |
| | FR - A - 1 554 398 (GENERAL ELECTRIC)<br><br>* Page 1, column 1, lines 9-14; page 1, column 2, lines 13-27; figures *<br><br>--- | 1 | H 01 G 9/20<br>H 01 M 14/00 |
| | US - A - 4 084 044 (BELL TELEPHONE LABORATORIES)<br><br>* Columns 1,2,3; claims 1-3; figure 2 *<br><br>----- | 1-5 | |

TECHNICAL FIELDS SEARCHED (Int. Cl.³)

H 01 G 9/20
H 01 M 14/00
H 01 L 31/06

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| THE HAGUE | 08-10-1980 | ROUBERT |

EPO Form 1503.1 06.78